(19) Europäisches Patentamt
European Patent Office
Office européen des brevets

(11) **EP 2 460 027 B1**

(12) **EUROPÄISCHE PATENTSCHRIFT**

(45) Veröffentlichungstag und Bekanntmachung des Hinweises auf die Patenterteilung:
**28.08.2013 Patentblatt 2013/35**

(21) Anmeldenummer: **09781216.8**

(22) Anmeldetag: **29.07.2009**

(51) Int Cl.:
*G01R 33/04* (2006.01)    *G01N 27/90* (2006.01)
*G01N 29/14* (2006.01)    *B06B 1/08* (2006.01)

(86) Internationale Anmeldenummer:
**PCT/EP2009/059777**

(87) Internationale Veröffentlichungsnummer:
**WO 2011/012159 (03.02.2011 Gazette 2011/05)**

(54) **VERFAHREN ZUR KLASSIFIZIERUNG VON ELEKTROBLECH**

METHOD FOR CLASSIFYING ELECTRICAL SHEET

PROCÉDÉ DE CLASSIFICATION DE TÔLE ÉLECTRIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**06.06.2012 Patentblatt 2012/23**

(73) Patentinhaber: **Siemens AG Österreich**
**1210 Wien (AT)**

(72) Erfinder: **PREGARTNER, Helmut**
**A-8160 Krottendorf (AT)**

(74) Vertreter: **Maier, Daniel Oliver**
**Siemens AG**
**Postfach 22 16 34**
**80506 München (DE)**

(56) Entgegenhaltungen:
**CN-A- 101 354 380      US-A- 5 456 113**
**US-A1- 2007 046 289**

**Beschreibung**

Technisches Gebiet

Die Erfindung betrifft ein Verfahren zur Klassifizierung von Elektroblech, welches für die Herstellung einer elektrischen Maschine verwendet wird und in Form eines Bandwickels vorliegt.

Stand der Technik

Die bei Betrieb einer elektrischen Anlage, z.B. eines Leistungstransformators auftretende Geräuschemission wird insbesondere dann als störend empfunden, wenn die Anlage in der Nähe eines Wohnbereiches installiert ist. Bei der Herstellung eines geräuscharmen Leistungstransformators ist man daher bestrebt, ein weichmagnetisches Material zu verwenden, das eine möglichst geringe Magnetostriktion aufweist. In der Praxis erweist sich aber die Klassifizierung von weichmagnetischen Materialien als schwierig. Üblicherweise wird zum Zwecke der Klassifizierung aus einem Bandwickel (aus dem in einem späteren Verarbeitungsschritt die Blechteile für den Transformatorkern gestanzt werden) eine Probe entnommen und in einer Messeinrichtung hinsichtlich des Magnetostriktions-Verhaltens und anderer magnetische Eigenschaften analysiert. Dabei tritt zunächst das Problem auf, dass bekannte Messeinrichtungen nicht übereinstimmende Messergebnisse liefern. Zum anderen ist das Messergebnis vom Ort der Probenentnahme abhängig: Es kann sein, dass eine am Anfang eines Bandwickels entnommene Probe und eine am Ende des Bandwickels entnommene Probe jeweils ein stark unterschiedliches Magnetostriktions-Verhalten zeigen. Eine zufriedenstellende Vorhersage für das Geräuschverhalten der elektrischen Maschine ist mit bekannten Mess- und Klassifizierungsmethoden kaum möglich. Relevanter Stand der Technik ist z.B US 5456113, CN 101354380 oder US2007/00462bzw. US5581037.

Darstellungen der Erfindung

Es ist eine Aufgabe der vorliegenden Erfindung, ein Verfahren zur Klassifizierung von Elektroblech anzugeben, mit dem das Geräuschverhalten und gegebenenfalls auch die magnetischen Verluste einer elektrischen Maschine besser vorhergesagt werden können.

Diese Aufgabe wird durch ein Verfahren mit den Merkmalen des Patentanspruchs 1 gelöst. Vorteilhafte Ausgestaltungen sind in abhängigen Ansprüchen definiert.

In einem Grundgedanken geht die Erfindung davon aus, für die Klassifizierung des weichmagnetischen Ausgangsproduktes nicht eine dem angelieferten Material entnommene Probe zu untersuchen, sondern den Bandwickel im Ganzen, so wie er bei der Fertigungsstätte angeliefert wird. Hierfür wird der Blechwickel, oder auch Coil genannt, mit einer Erregerwicklung versehen. Mittels einer Speiseeinrichtung wird im gewickelten Flachband ein zeitlich veränderlicher magnetischer Fluss erzeugt. Dieser zeitlich veränderliche magnetische Fluss hat aufgrund der Magnetostriktion eine Formänderung des Bandwickels zur Folge. Entsprechend der Magnetostriktion entstehen Schwingungen in Vorzugrichtung des magnetischen Werkstoffs. Mittels einer Messeinrichtung werden die quer zur Vorzugsrichtung verlaufende Formänderungen des Bandwickels und gegebenenfalls auch die magnetischen Verluste gemessen und einer Auswerteeinrichtung zugeführt. In der Auswerteeinrichtung erfolgt die Berechnung von Geräuschpegeln (Schallleistungspegeln) und Verlustkennziffern und die Zuordnung dieser Werte zu Klassen. Auf diese Weise kann das zu erwartende Betriebsverhalten der elektrischen Maschine, das heißt mit Blick auf das zu erwartende Geräuschverhalten und gegebenenfalls auch hinsichtlich der zu erwartenden magnetischen Verluste, besser vorhergesagt werden. Durch das erfindungsgemäße Verfahren können vor Beginn der Produktion aus den angelieferten Bandwickeln jene herausgefiltert werden, die für einen geräuscharmen Betrieb einer elektrischen Maschine als besonders bzw. als weniger gut geeignet erscheinen. Da das Coil in seiner Gesamtheit bewertet wird, ist das Klassifizierungsergebnis nicht mehr abhängig vom Ort einer Probenentnahme. Die Prognose ist mit dem erfindungsgemäßen Verfahren weitaus treffsicherer. Insbesondere bei der Herstellung von großen Maschinen, wie beispielsweise geräuscharmen Leistungstransformatoren, ist das erfindungsgemäße Verfahren von hoher wirtschaftlicher Bedeutung. Die Auswerteeinrichtung, welche die Klassifizierung beziehungsweise Kategorisierung des Elektroblechs durchführt, kann auf der Grundlage vorgegebener Merkmale (Geräuschpegel, Verluste) die Einteilung in Klassen automatisch vornehmen. Die Auswerteeinheit ist z.B. ein entsprechend modifizierter Personal Computer (PC), der vergleichsweise einfach aus an sich bekannten Hardware- und Softwarekomponenten zusammengesetzt gesetzt sein kann. Die Zuordnung des Elektroblechs zu Geräuschklassen erfordert in der Produktion nur einen geringen Aufwand. Das Klassifizierungs-Verfahren ist kaum störanfällig.

In axialer Richtung des Blechwickels lässt sich die Formänderung des Bandwickels messtechnisch besonders einfach erfassen, indem an einer oder gegebenenfalls an beiden Stirnflächen des Bandwickels eine Sensoreinrichtung angeordnet wird, welche die Schwingungen in axialer Richtung des Bandwickels erfasst.

Wenn an jeder Stirnfläche mehrere Detektoren angeordnet werden, kann auf einfache Weise eine Mittelung der Längenänderung durchgeführt werden.

Zum Detektieren der Formänderung des Coils können vorteilhaft herkömmlich verfügbare Beschleunigungssensoren verwendet werden. Aus dem Signal eines Beschleunigungssensors lässt sich auf einfache Weise ein Geschwindigkeitssignal berechnen, welches in einer weiteren Folge durch Fourieranalyse in einzelne Frequenzkomponenten zerlegt werden kann. Das Schwingungsspektrum kann dann vergleichsweise einfach in ein dem Geräusch proportionales Spektrum umgerechnet und in einem weitern Schritt einer Geräuschklasse zugeordnet werden.

Es ist zweckmäßig, wenn bei der Klassifizierung des Elektroblechs die späteren Betriebsbedingungen der elektrischen Maschine bereits berücksichtigt werden, das heißt die Erregerwicklung wird mit 50 Hz (Europa) beziehungsweise 60 Hz (USA) und veränderbarer Amplitude gespeist.

Es hat sich herausgestellt, dass es günstig sein kann, wenn der mittels der Erregerwicklung im Bandwickel erzeugte magnetische Fluss in einem technisch relevanten Intervall zwischen 0,5 T bis 2 T stufenweise vorgegeben wird. In der Praxis haben sich dabei Stufen von etwa 0,1 T als günstig herausgestellt. Dadurch kann das zu erwartende Geräuschverhalten in Abhängigkeit der magnetischen Aussteuerung ermittelt werden.

Eine gute Klassifizierung des Geräuschverhaltens des Elektroblechs lässt sich insbesondere dann erreichen, wenn bei der Auswertung der Messesignale der Detektoren nur Geschwindigkeitsamplituden ganzzahliger Vielfachen der vorgegebenen Frequenz (100 Hz, 150 Hz, 200 Hz,... beziehungsweise 120 Hz, 180 Hz, 240 Hz,...) verwendet werden.

Ferner kann es günstig sein, wenn die spektralen Geschwindigkeitsanteile auf eine bestimmte Breite des Bandwickels, beispielsweise auf eine Breite von 1 m, normiert werden. Dadurch ist die Klassifikation unabhängig von der Größe der angelieferten Coils möglich.

Eine besonders präzise Vorhersage lässt sich dadurch erreichen, wenn die Schwingungen des Bandwickels durch mehrere Sensoren an einer oder an beiden Stirnseiten erfasst werden und diese Messesignale gemittelt werden.

Günstig ist, wenn die gemessenen Werte in Geräuschpegeln (Schallleistungspegeln) umgerechnet und in einer Datenbank abgespeichert werden, so dass zu bestimmten Werten der magnetische Flussdichte jeweils eine bestimmte bei Betrieb auftretende Formänderung des Blechmaterials zugeordnet werden kann.

Als Sensoren zum Erfassen der Deformation können dabei unterschiedliche Messprinzipien zum Einsatz kommen; beispielsweise Piezo-Aufnehmer, Laserinterferometer, ohmsche, kapazitive oder induktive Messumformer.

Kurzbeschreibung der Zeichnungen

Zur weiteren Erläuterung der Erfindung wird im nachfolgenden Teil der Beschreibung auf die Zeichnungen Bezug genommen, in denen weitere vorteilhafte Ausgestaltungen, Einzelheiten und Weiterbildungen der Erfindung zu entnehmen sind.

Es zeigt:

Figur 1    einen Bandwickel mit einer Erregerwicklung und einer erfindungsgemäßen Mess- und Auswerteeinrichtung zur Klassifizierung des Bandwickels hinsichtlich Geräuschemission und Verluste in einer schematischen Darstellung;

Figur 2    eine Detaildarstellung der Figur 1, in welcher die Anordnung einer Beschleunigungs-Sensoreinrichtung an einer Stirnfläche des Bandwickels im Schnitt dargestellt ist;

Figur 3    eine Detaildarstellung der Figur 1, in welcher die Anordnung einer optischen Sensoreinrichtung an einer Stirnfläche des Bandwickels im Schnitt dargestellt ist.

Ausführung der Erfindung

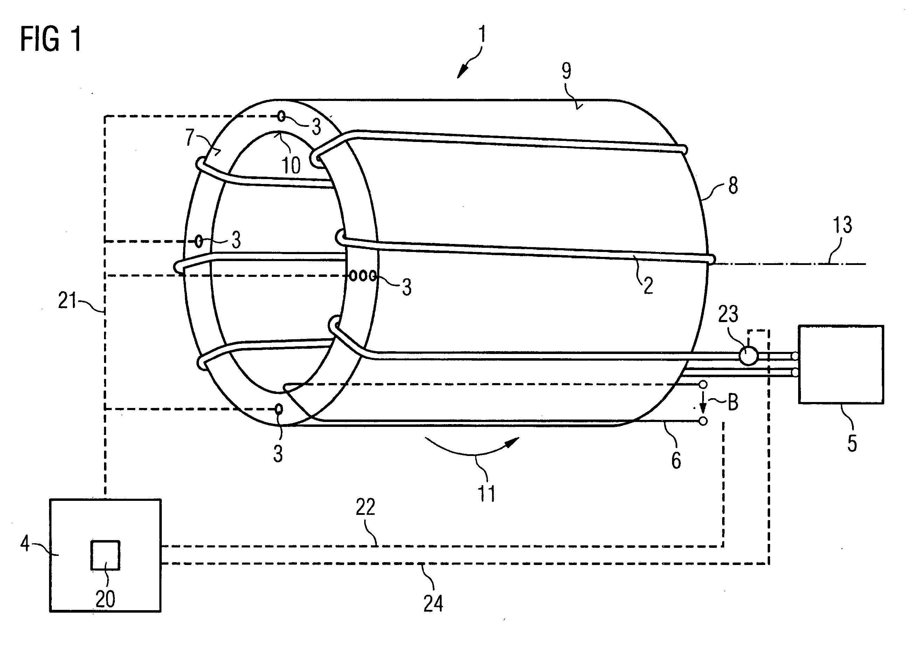

Die Figur 1 zeigt in einer räumlichen Skizze einen hohlzylindrischen Bandwickel 1. Bei der Herstellung einer elektrischen Maschine, wie beispielsweise eines Leistungstransformators, stellt ein solcher Bandwickel 1 das Ausgangsprodukt dar, aus dem in einem späteren Verarbeitungsschritte die einzelnen Blechteile des weichmagnetischen Trafokerns gestanzt werden. Üblicherweise hat ein solcher Bandwickel im Großmaschinenbau etwa einen Durchmesser von bis zu 900 mm, eine Breite von 70 cm bis 1 m und eine Masse von etwa 1 bis 5 Tonnen.

Wie bereits eingangs erwähnt, zeigt die Praxis, dass das Geräuschverhalten von elektrischen Maschinen, die aus einem solchen Ausgangsmaterial hergestellten werden, von Bandwickel zu Bandwickel mehr oder weniger stark variiert. Bei der Herstellung einer geräuscharmen elektrischen Maschine ist man aber bestrebt, ein weichmagnetisches Material mit möglichst günstigen Magnetostriktions-Eigenschaften zu verwenden.

Gemäß der Erfindung wird nun ein Bandwickel oder Coil 1 (in dieser Form wird das Material üblicher Weise bei der Produktion einer elektrischen Maschine angeliefert) im Ganzen klassifiziert beziehungsweise kategorisiert. Hierfür wird das Coil 1 mit einer Erregerwicklung 2 versehen. Wie aus Figur 1 zu sehen ist, erstreckt sich diese Erregerwicklung 2 quer zur Umfangsrichtung 11 in Richtung der Achse 13 und umschlingt spiralförmig die äußere Mantelfläche 9, die Stirnflächen 7 und 8, sowie die innere Mantelfläche 10 des hohlzylindrischen Bandwickels 1. Die Erregerwicklung 2 steht mit einer Speiseeinrichtung 5 in Verbindung. Die Speiseeinrichtung 5 versorgt die Erregerwicklung 2 mit einer hinsichtlich Frequenz und Amplitude einstellbaren sinusförmigen Speisespannung.

Zur Klassifizierung des Bandwickels hinsichtlich Geräuschemission wird nun an die Erregerwicklung 2 eine sinusförmige Spannung bevorzugt mit z.B. 50 Hz oder 60 Hz angelegt. Der in der Erregerwicklung 2 fließende Wechselstrom bewirkt, dass sich im Bandwickel 1 ein in Umfangsrichtung 11 gerichteter magnetischer Wechselfluss ausbildet.

Der in die Erregerwicklung eingespeiste Strom wird mittels eines Stromsensors 23 erfasst. Der vom Stromsensor 23 bereitgestellte Messwert 24 wird einer Auswerteeinheit 4 zugeleitet.

Um den durch die Erregerwicklung 2 hervorgerufenen magnetischen Fluss im Blechwickel 1 zu erfassen, ist um den Bandwickel 1 eine Messschleife 6 angeordnet. Bei einer Flussänderung im Blechwickel 1 wird in der Messschleife 6 eine Spannung induziert, welche proportional zur magnetischen Flussdichte B ist. Die induzierte Spannung wird als Messwert 22 der Auswerteeinrichtung 4 zugeleitet.

Der in Umfangsrichtung 11 des Bandwickels 1 sich ausbreitende magnetische Wechselfluss bewirkt durch die Magnetostriktion des weichmagnetischen Materials eine Formänderung des Bandwickels 1. Es kommt sowohl zu einer Änderung der Wickellänge, als auch zu einer Querkontraktion, das heißt zu einer Änderung der axialen Länge des Bandwickels 1.

Um diese Deformation zu erfassen, ist an der Stirnfläche 7 eine Sensoreinrichtung 3 angeordnet. Die Sensoren 3 liefern Messesignale 21, welche ebenfalls der Auswerteeinrichtung 4 zugeführt sind.

Zur Klassifizierung des Bandwickels hinsichtlich Geräuschemission wird nun die Speisespannung der Erregerwicklung 2 stufenweise verändert, bis ein bestimmter Wert der Flussdichte im Bandwickel 1 erreicht ist. Für diese eingestellte Flussdichte werden die von den Sensoren 3 bereitgestellten Messesignale in der Auswerteeinrichtung 4 wie folgt ausgewertet:

In der Auswerteeinrichtung 4 werden mittels einer Fourier-Analyse die Messesignale der Sensoren 3 in FrequenzKomponenten zerlegt. Dabei werden nur die Geschwindigkeitsamplituden der ganzzahligen Vielfachen von 50 Hz bzw. 60 Hz betrachtet.

Die spektralen Geschwindigkeits-Amplituden werden auf eine Längeneinheit des Bandwickels 1, beispielsweise auf einen Meter Blechbreite des Bandwickels 1 normiert. Für jede Frequenzkomponenten wird ein Mittelwert gebildet:

$$\overline{V}_j = \frac{1}{M}\sum_{i=1}^{M} v_{j,i}$$

$V_j$. mittlere Geschwindigkeit bei Frequenz j

M. Anzahl der Aufnehmer

j   j'te Frequenzkomponente (z.B. 100 Hz Komp.)

Anschließend wird für jede Frequenzkomponente ein gemittelter Schallleistungspegel berechnet.

$$L_{W,j} = 10 \cdot C_j \cdot \log(\overline{V}_j)^2$$

$C_j$. Anpassfaktor

Die Anpassungsfaktoren $C_j$ berücksichtigt Unterschiede in der Schallabstrahlung unterschiedlicher Frequenzkomponenten j. Die Anpassungsfaktoren $C_j$ werden quantitativ so gewählt, dass sie den Zusammenhang zwischen einer schwingenden Fläche von 1 $m^2$ und der Schallleistung $L_w$ darstellen.

In einem weiteren Schritt werden der unbewertete und der A-bewertete Schallleistungspegel gemäß der Formel

$$L_W = 10 \cdot \log\left( \sum_{j=1}^{N} 10^{0,1*L_{W,j}} \right)$$

N.     Anzahl der 50 Hz Vielfachen beziehungsweise

$$L_{WA} = 10 \cdot \log\left( \sum_{j=1}^{N} 10^{0,1*(L_{W,j} - A_j)} \right)$$

$A_j$     A-Bewertung bei der Frequenz $f_j$ berechnet.

In der Auswerteeinrichtung 4 ist eine als Datenbank ausgebildete Speichereinrichtung 20 implementiert, in welcher Messwerte der Flussdichte, die berechneten relativen Gesamt-Schallleistungspegel und spektralen Komponenten abgelegt sind. Unter Heranziehung dieser Werte können die Bandwickel sortiert werden und somit der Einfluss eines Bandwickels auf das Geräuschverhalten einer elektrischen Maschine besser vorhergesagt werden.

Für jeden vorgegebenen Wert der magnetischen Flussdichte wird mittels Auswerteeinrichtung 4 gleichzeitig auch der magnetische Verlustwert und der Magnetisierungsbedarf des Blechwickels ermittelt. Diese Werte werden ebenfalls in der Datenbank 20 abgelegt. Dadurch ist es möglich, auch die Magnetisierungsverluste und den Magnetisierungsstrombedarf einer elektrischen Maschine genauer vorherzusagen.

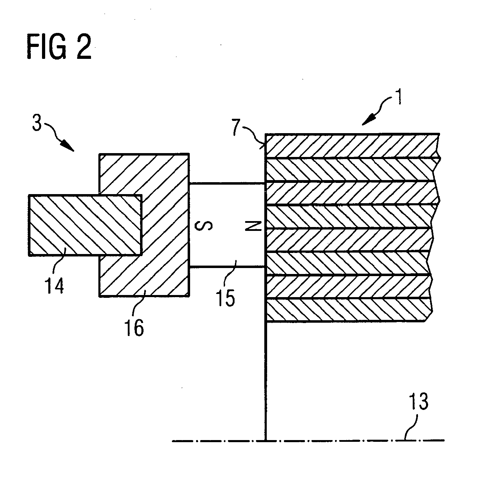

Die Figur 2 zeigt eine mögliche Anordnung einer Sensoreinrichtung 3. Dargestellt ist eine beispielhafte Ausführungsform, bei der der Sensor 3 als ein Beschleunigungssensor 14 ausgebildet ist und mittels eines Zwischenstückes 16 und mittels eines Dauermagneten 15 an einer Stirnfläche 7 des hohlzylindrischen Bandwickels 1 angeordnet ist. Der Beschleunigungssensor 14 erfasst die axiale Deformation des Blechwickels 1, welche durch den magnetischen Wechselfluss im Blechwickel 1 erzeugt wird. Die Messinformation wird als Messsignal 21 der Auswerteeinheit 4 zugeführt (siehe Figur 1). Die Befestigung des Sensors 3 könnte auch anders erfolgen, beispielsweise durch eine Klebe- oder Wachsverbindung. Wie bereits erwähnt, können auf der Stirnfläche 7 mehrere Sensoren auf diese oder andere Weise befestigt sein.

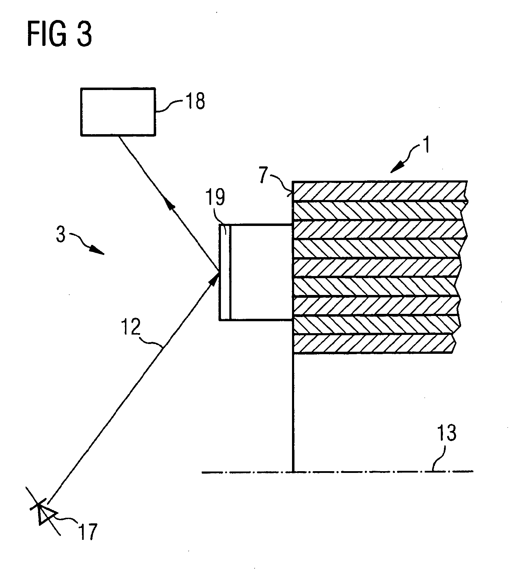

In der Figur 3 ist eine andere Ausführung der Sensoreinrichtung gezeigt. Die Sensoreinrichtung 3 ist hier als optische Sensoreinrichtung ausgebildet. Eine optische Sendeeinrichtung 17 erzeugt einen auf einem Reflektor 19 gerichteten Lichtstrahl 12. Dieser Lichtstrahl 12 wird gemäß der Magnetostriktion des weichmagnetischen Werkstoffs unterschiedlich reflektiert, was ein optischer Detektor 18 erkennt. Die Messinformation des Detektors 18 ist wieder der Auswerteeinheit 4 zugeleitet.

Zum Erfassen der Deformation des Blechwickels 1 sind wie bereits erwähnt auch andere Messmethoden denkbar, beispielsweise ohmsche, kapazitive oder induktive Messaufnehmer.

Das erfindungsgemäße Verfahren ermöglicht Bandwickel (Coil) in einer Klasse zusammen zufassen, und zwar gleichzeitig sowohl hinsichtlich der zu erwartenden Geräuschemission, als auch der magnetischen Verluste und des Magnetisierungsstrombedarfes. Unterschiedliche Materialeigenschaften am Anfang und am Ende des Bandwickels fallen durch die Gesamtbewertung des Coil weg.

Zusammenstellung der verwendeten Bezugszeichen

1     Bandwickel (Coil)
2     Erregerwicklung
3     Sensoreinrichtung
4     Auswerteeinrichtung

| 5 | Speiseeinrichtung |
|---|---|
| 6 | Messschleife |
| 7 | Stirnfläche |
| 8 | Stirnfläche |
| 9 | äußere Mantelfläche |
| 10 | innere Mantelfläche |
| 11 | Umfangsrichtung |
| 12 | Lichtstrahl |
| 13 | Achse |
| 14 | Beschleunigungssensor |
| 15 | Permanentmagnet |
| 16 | Zwischenstück |
| 17 | optische Sendeeinrichtung |
| 18 | optische Empfangseinrichtung |
| 19 | Reflektor |
| 20 | Speichereinrichtung, Datenbank |
| 21 | Messsignal der Sensoren 3 |
| 22 | Messsignal der in 6 induzierten Spannung (magnetische Flussdichte B in Coil 1) |
| 23 | Stromsensor |
| 24 | Messsignal des Stromsensors 23 |

**Patentansprüche**

1. Verfahren zur Klassifizierung von Elektroblech, das für die Herstellung einer elektrischen Maschine verwendet wird und in Form eines Bandwickels (1) vorliegt, **dadurch gekennzeichnet,**

 - **dass** im Bandwickel (1) mittels einer von einer Speiseeinrichtung (5) gespeisten Erregerwicklung (2) ein zeitlich veränderlicher magnetischer Fluss erzeugt wird, der eine Formänderung des Bandwickels (1) und magnetische Verluste verursacht,
 - **dass** die Formänderung und/oder die magnetischen Verluste mittels einer Messeinrichtung (3, 6, 23) gemessen werden und das dabei gewonnene Messsignal (21, 22, 24) einer Auswerteeinrichtung (4) zugeführt wird, und
 - **dass** die Auswerteeinrichtung (4) unter Verwendung des Messsignals (21, 22, 24) eine Kategorisierung des Elektroblechs hinsichtlich Geräuschemission und/oder magnetischer Verluste durchführt.

2. Verfahren nach Anspruch 1, **dadurch gekennzeichnet, dass** die Messeinrichtung (3, 6, 23) eine Sensoreinrichtung (3) aufweist, die an einer oder an beiden Stirnflächen (7, 8) des Bandwickels (1) angeordnet wird.

3. Verfahren nach Anspruch 2, **dadurch gekennzeichnet, dass** die Sensoreinrichtung (3) durch zumindest einen Beschleunigungssensor (14) gebildet wird.

4. Verfahren nach Anspruch 3, **dadurch gekennzeichnet, dass** der zumindest eine Beschleunigungssensor (14) ein Messsignalsignal (21) erzeugt, welches in der Auswerteeinrichtung (4) in ein Geschwindigkeitssignal umgerechnet wird, welches anschließend in Frequenzkomponenten zerlegt wird.

5. Verfahren nach Anspruch 4, **dadurch gekennzeichnet, dass** in der Auswerteeinrichtung (4) eine schnelle Fouriertransformation (FFT) durchgeführt wird.

6. Verfahren nach Anspruch 5, **dadurch gekennzeichnet, dass** die Erregerwicklung (2) mit einer sinusförmigen Speisespannung vorgebbarer Frequenz, insbesondere mit einer Frequenz von 50 Hz oder 60 Hz, und vorgebbarer Amplitude gespeist wird.

7. Verfahren nach Anspruch 6, **dadurch gekennzeichnet, dass** der magnetische Fluss in einem technisch relevanten Bereich zwischen 0,5 T und 2 T in Stufen, insbesondere in 0,1 T - Stufen, vorgegeben wird.

8. Verfahren nach Anspruch 7, **dadurch gekennzeichnet, dass** für die Kategorisierung des Elektroblechs nur Geschwindigkeitsamplituden der ganzzahligen Vielfachen der vorgegebenen Frequenz verwendet werden.

9. Verfahren nach Anspruch 8, **dadurch gekennzeichnet, dass** die Geschwindigkeitsamplituden auf eine Breiteneinheit des Bandwickels (1), insbesondere auf eine Breite von 1m, normiert werden.

10. Verfahren nach Anspruch 9, **dadurch gekennzeichnet, dass** in der Auswerteeinrichtung (4) aus spektralen Geschwindigkeitsamplituden ein Mittelwert gemäß der Formel

$$\overline{V}_j = \frac{1}{M}\sum_{i=1}^{M} v_{j,i}$$

$V_j$. mittlere Geschwindigkeit bei Frequenz j
M. Anzahl der Aufnehmer
j. j' te Frequenzkomponente (z.B. 100 Hz Komp.).

gebildet wird.

11. Verfahren nach Anspruch 10, **dadurch gekennzeichnet, dass** für jede Frequenzkomponente der Fast-Fourier-Analyse ein gemittelter Schallleistungspegel gemäß der Formel

$$L_{W,j} = 10 \cdot C_j \cdot \log(\overline{V}_j)^2$$

$C_j$ Anpassfaktor

gebildet wird.

12. Verfahren nach Anspruch 11, **dadurch gekennzeichnet, dass** in der Auswerteeinrichtung (4) unter Verwendung der Formel

$$L_W = 10 \cdot \log\left(\sum_{j=1}^{N} 10^{0,1*L_{W,j}}\right)$$

N. Anzahl der 50 Hz Vielfachen

ein Gesamt-Schallleistungspegel und ein A-bewerteter Gesamt-Schallleistungspegel gemäß der Formel

$$L_{WA} = 10 \cdot \log\left(\sum_{j=1}^{N} 10^{0,1*(L_{W,j}-A_j)}\right)$$

$A_j$... A-Bewertung bei der Frequenz $f_j$ errechnet wird.

**13.** Verfahren nach Anspruch 12, **dadurch gekennzeichnet, dass** die Messeinrichtung (3, 6, 23) eine Messschleife (6) aufweist, welche die magnetische Flussdichte im Bandwickel (1) als Messwert (22) erfasst und dieser Messwert (22) der Auswerteeinrichtung (4) zugeführt wird.

**14.** Verfahren nach Anspruch 13, **dadurch gekennzeichnet, dass** die berechneten relativen Gesamt-Schallleistungspegel und spektralen Komponenten und Messwerte der magnetischen Flussdichte in einer Speichereinrichtung (20) der Auswerteeinrichtung (4) gespeicherten werden.

**15.** Verfahren nach Anspruch 14, **dadurch gekennzeichnet, dass** in der Auswerteeinrichtung (4) jeweils für einen Wert einer magnetischen Flussdichte im Bandwickel (1) ein Verlustwert berechnet und in der Speichereinrichtung (20) abgelegt werden.

**Claims**

**1.** Method for classifying electric sheet steel that is used to manufacture an electrical machine and is present in the form of a strip roll (1), **characterised in that**

- a magnetic flux that changes over time is generated in the strip roll (1) by means of an excitation winding (2) supplied by a supply device (5), said magnetic flux causing a change in shape of the strip roll (1) and magnetic losses,
- the change in shape and/or the magnetic losses are measured by means of a measuring device (3, 6, 23) and the thus obtained measurement signal (21, 22, 24) is passed to an evaluation device (4), and
- the evaluation device (4) uses the measurement signal (21, 22, 24) to perform a catégorisation of the electric sheet steel with regard to noise emission and/or magnetic losses.

**2.** Method according to claim 1, **characterised in that** the measuring device (3, 6, 23) has a sensor device (3) which is arranged on one or both end faces (7, 8) of the strip roll (1).

**3.** Method according to claim 2, **characterised in that** the sensor device (3) is formed by at least one acceleration sensor (14).

**4.** Method according to claim 3, **characterised in that** the at least one acceleration sensor (14) generates a measurement signal (21) which is converted in the evaluation device (4) into a speed signal, which is then decomposed into frequency components.

**5.** Method according to claim 4, **characterised in that** a fast Fourier transform (FFT) is performed in the evaluation device (4).

**6.** Method according to claim 5, **characterised in that** the excitation winding (2) is supplied with a sinusoidal supply voltage of predeterminable frequency, in particular with a frequency of 50 Hz or 60 Hz, and of predeterminable amplitude.

**7.** Method according to claim 6, **characterised in that** the magnetic flux is predetermined in a technically relevant range between 0.5 T and 2 T in steps, in particular in 0.1 T steps.

**8.** Method according to claim 7, **characterised in that** only speed amplitudes of the integral multiples of the predetermined frequency are used for categorizing the electric sheet steel.

**9.** Method according to claim 8, **characterised in that** the speed amplitudes are normalised to a unit of width of the strip roll (1), and in particular to a width of 1 m.

**10.** Method according to claim 9, **characterised in that** a mean value is formed in the evaluation device (4) from spectral speed amplitudes in accordance with the formula

**EP 2 460 027 B1**

$$\overline{V}_j = \frac{1}{M} \sum_{i=1}^{M} v_{j,i}$$

$V_j$ Mean speed at frequency j
M Number of sensors
j j' th frequency component (e.g. 100 Hz comp.).

**11.** Method according to claim 10, **characterised in that** for each frequency component of the fast Fourier analysis a mean sound power level is formed according to the formula

$$L_{W,j} = 10 \cdot C_j \cdot \log(\overline{V}_j)^2$$

$C_j$ Adjustment factor

**12.** Method according to claim 11, **characterised in that** in the evaluation device (4) an overall sound power level is calculated according to the formula

$$L_W = 10 \cdot \log\left( \sum_{j=1}^{N} 10^{0,1*L_{W,j}} \right)$$

N Number of 50 Hz multiples

and an A-weighted overall sound power level is calculated according to the formula

$$L_{WA} = 10 \cdot \log\left( \sum_{j=1}^{N} 10^{0,1*(L_{W,j}-A_j)} \right)$$

$A_j$, A-weighting at the frequency $f_j$.

**13.** Method according to claim 12, **characterised in that** the measuring device (3, 6, 23) has a measuring loop (6) which records the magnetic flux density in the strip roll (1) as a measured value (22) and this measured value is fed (22) to the evaluation device (4).

**14.** Method according to claim 13, **characterised in that** the calculated relative overall sound power level and spectral components and measured values of the magnetic flux density are stored in a memory device (20) of the evaluation device (4).

**15.** Method according to claim 14, **characterised in that** in the evaluation device (4) a loss value is calculated and stored in the memory device (20) for each value of a magnetic flux density in the strip roll (1).

9

**Revendications**

1. Procédé de classification d'une tôle électrique qui est utilisée pour la fabrication d'une machine électrique et se présente sous la forme d'une bande enroulée (1), **caractérisé en ce que**

   - un flux magnétique variant dans le temps, qui provoque un changement de forme de la bande enroulée (1) et des pertes magnétiques, est généré dans la bande enroulée (1) au moyen d'un enroulement d'excitation (2) alimenté par un dispositif d'alimentation (5),
   - le changement de forme et/ou les pertes magnétiques sont mesurés au moyen d'un dispositif de mesure (3, 6, 23) et le signal de mesure (21, 22, 24) ainsi obtenu est envoyé à un dispositif d'évaluation (4), et
   - le dispositif d'évaluation (4) effectue une catégorisation de la tôle électrique en termes d'émission de bruit et/ou de pertes magnétiques en utilisant le signal de mesure (21, 22, 24).

2. Procédé selon la revendication 1, **caractérisé en ce que** le dispositif de mesure (3, 6, 23) comprend un dispositif de détection (3), placée sur une ou sur les deux faces frontales (7, 8) de la bande enroulée (1).

3. Procédé selon la revendication 2, **caractérisé en ce que** le dispositif de détection (3) est formé par au moins un capteur d'accélération (14).

4. Procédé selon la revendication 3, **caractérisé en ce que** le ou les capteurs d'accélération (14) produisent un signal de mesure (21) qui est converti en un signal de vitesse dans le dispositif d'évaluation (4), lequel signal de vitesse est ensuite décomposé en composantes de fréquence.

5. Procédé selon la revendication 4, **caractérisé en ce qu'**une transformation de Fourier rapide (FFT) est effectuée dans le dispositif d'évaluation (4).

6. Procédé selon la revendication 5, **caractérisé en ce que** l'enroulement d'excitation (2) est alimenté avec une tension d'alimentation sinusoïdale de fréquence prédéfinissable, en particulier avec une fréquence de 50 Hz ou 60 Hz, et d'amplitude prédéfinissable.

7. Procédé selon la revendication 6, **caractérisé en ce que** le flux magnétique est prédéfini dans une plage techniquement pertinente comprise entre 0,5 T et 2 T par paliers, en particulier par paliers de 0,1 T.

8. Procédé selon la revendication 7, **caractérisé en ce que** seules des amplitudes de vitesse des multiples entiers de la fréquence prédéfinie sont utilisées pour la catégorisation de la tôle électrique.

9. Procédé selon la revendication 8, **caractérisé en ce que** les amplitudes de vitesse sont normalisées à une unité de largeur de la bande enroulée (1), en particulier à une largeur de 1 m.

10. Procédé selon la revendication 9, **caractérisé en ce qu'**une valeur moyenne est formée dans le dispositif d'évaluation (4) à partir d'amplitudes de vitesse spectrales selon la formule

$$\overline{V}_j = \frac{1}{M}\sum_{i=1}^{M} v_{j,i}$$

$V_j$. vitesse moyenne à la fréquence j
M nombre de capteurs
j. jième composante de fréquence (p.ex. comp. 100 Hz).

11. Procédé selon la revendication 10, **caractérisé en ce qu'**un niveau de puissance acoustique moyenné est formé pour chaque composante de fréquence de l'analyse de Fourier rapide selon la formule

$$L_{W,j} = 10 \cdot C_j \cdot \log(\overline{V}_j)^2$$

$C_j$. facteur d'adaptation.

**12.** Procédé selon la revendication 11, **caractérisé en ce que** dans le dispositif d'évaluation (4) un niveau de puissance acoustique total est calculé en utilisant la formule

$$L_W = 10 \cdot \log\left( \sum_{j=1}^{N} 10^{0,1*L_{W,j}} \right)$$

N nombre des multiples de 50 Hz

et un niveau de puissance acoustique total pondéré A est calculé selon la formule

$$L_{WA} = 10 \cdot \log\left( \sum_{j=1}^{N} 10^{0,1*(L_{W,j}-A_j)} \right)$$

$A_j$ pondération A à la fréquence $f_j$.

**13.** Procédé selon la revendication 12, **caractérisé en ce que** le dispositif de mesure (3, 6, 23) comprend une boucle de mesure (6) qui détecte la densité de flux magnétique dans la bande enroulée (1) comme valeur de mesure (22), et cette valeur de mesure (22) est envoyée au dispositif d'évaluation (4).

**14.** Procédé selon la revendication 13, **caractérisé en ce que** les niveaux de puissance acoustique totaux relatifs calculés et les composantes spectrales et valeurs de mesure de la densité de flux magnétique sont enregistrés dans un dispositif de mémoire (20) du dispositif d'évaluation (4).

**15.** Procédé selon la revendication 14, **caractérisé en ce que** pour chaque valeur d'une densité de flux magnétique dans la bande enroulée (1) une valeur de perte est calculée dans le dispositif d'évaluation (4) et déposée dans le dispositif de mémoire (20).

FIG 1

EP 2 460 027 B1

FIG 2

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5456113 A
- CN 101354380
- US 200700462 B
- US 5581037 A